# FASCICULE DE BREVET EUROPEEN

(11) **EP 0 944 151 B1**
(45) Date de publication et mention de la délivrance du brevet: **03.12.2003**
(21) Numéro de dépôt: 98104915.8
(22) Date de dépôt: 18.03.1998
(51) Int. Cl.: H02H 9/04, H01L 27/02

(54) **Structure de protection d'un circuit contre des décharges électrostatiques**
Schutzstruktur einer Schaltung gegen elektrostatische Entladung
Protective circuit structure against electrostatic discharges

(43) Date de publication de la demande: 22.09.1999
(73) Titulaire: EM Microelectronic-Marin SA, 2074 Marin (CH)
(72) Inventeur: Roz, Thierry, 2515 Prêles (CH)
(74) Mandataire: Patry, Didier Marcel Pierre

(56) Documents cités:
- EP-A- 0 533 640
- EP-A- 0 587 212
- EP-A- 0 681 365
- US-A- 4 829 350

## Description

La présente invention concerne le domaine des structures de protection de circuits contre des décharges électrostatiques. La présente invention concerne également le domaine des structures de circuit intégré permettant d'appliquer, sur une borne externe d'un circuit connectée à une telle structure, des potentiels électriques supérieurs au potentiel d'alimentation fourni au circuit, ainsi que des potentiels électriques inférieurs au potentiel de masse de ce circuit.

Il est connu que des décharges électrostatiques provoquent des dégradations durables dans les circuits intégrés qui les subissent. Ce phénomène a été largement étudié et bon nombre de structures intégrées ont été réalisées pour protéger lesdits circuits contre de telles décharges. L'une des structures les plus efficaces pour réaliser une telle protection est communément appelée SCR, acronyme provenant de l'anglais "silicon controlled rectifier".

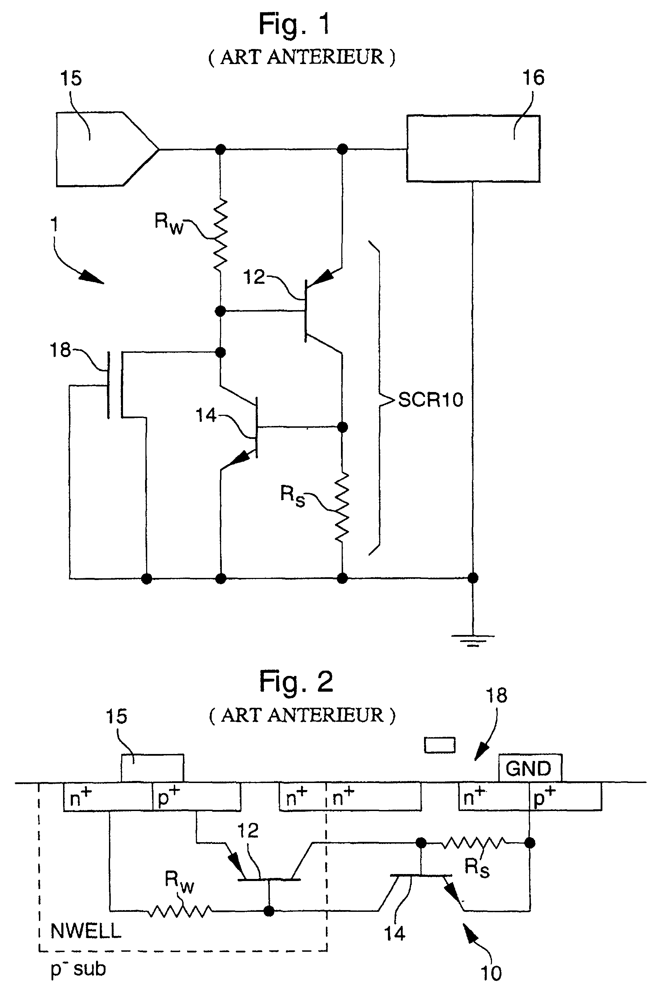

Le brevet américain N° 5.400.202 décrit un circuit de protection contre les décharges électrostatiques comprenant une structure SCR. Les figures 1 et 2 de la présente description représentent respectivement un schéma électrique d'un tel circuit, et une vue en coupe transversale d'un substrat semi-conducteur dans lequel est formé ce circuit.

Pour l'essentiel, le circuit désigné par la référence 1 comprend une structure SCR 10 formée par un transistor bipolaire de type 12 PNP, et par un transistor bipolaire de type 14 NPN.

Les transistors 12 et 14 sont couplés transversalement entre un plot de connexion 15 d'un circuit intégré 16 à protéger, et la masse de ce circuit. Plus précisément, la borne d'émetteur du transistor 12 est connectée au plot 15, ainsi que la borne de collecteur du transistor 14 par l'intermédiaire d'une résistance Rw. et la borne d'émetteur du transistor 14 est connectée à la masse du circuit 16, ainsi que la borne de collecteur du transistor 12 par l'intermédiaire d'une résistance Rs.

Comme le représente la figure 2, le transistor 12 est formé dans une zone de caisson ayant une conductivité de type N, cette zone étant désignée par la référence "NWELL", et le transistor 14 est formé dans un substrat ayant une conductivité de type P⁻, ce substrat étant désigné par la référence "p-sub". Les résistances de la zone NWELL et du substrat dans lesquels est formée la structure SCR 10 dans son ensemble correspondent respectivement aux résistances Rw et Rs.

Le circuit 1 comprend en outre un transistor à effet de champ 18 à canal N pour abaisser la tension de déclenchement de la structure SCR 10 à une valeur égale à la tension d'avalanche du transistor 18.

Un inconvénient d'un tel circuit de protection 1 réside dans le fait que, suite à une décharge électrostatique, le transistor 18 peut ne pas se déclencher, ce qui n'assure pas une bonne immunité aux surtensions électriques induites par de telles décharges, comme cela est décrit de façon plus détaillée dans le brevet américain déjà cité N° 5.400.202.

Pour pallier cet inconvénient, ce brevet américain décrit d'autres structures de protection. Toutefois, ces dernières ne répondent pas de manière satisfaisante aux préoccupations habituelles dans l'industrie des semi-conducteurs, relatives à la rationalisation, à l'encombrement et au coût.

Un autre inconvénient d'une structure de protection telle que décrite en relation avec les figures 1 et 2, réside dans le fait qu'elle ne permet pas l'application de potentiels électriques supérieurs au potentiel d'alimentation du circuit protégé par cette structure, ni l'application de potentiels électriques inférieurs au potentiel de masse de ce circuit.

En outre, la Demanderesse de la présente invention a observé que cet inconvénient ne permet pas la mise en oeuvre d'une structure de protection de ce type par exemple dans un transpondeur actif.

On peut citer également la demande de brevet européenne N° 0 587 212 qui décrit une structure de protection d'un circuit intégré contre des décharges électrostatiques. Cette structure comprend un premier transistor bipolaire, qui a son émetteur connecté à une borne externe du circuit intégré et son collecteur relié à la masse. La structure comprend encore un second transistor bipolaire, qui a son émetteur connecté à la borne externe du circuit intégré, et son collecteur relié à sa base et à la base du premier transistor, une diode étant connectée inversement entre le collecteur du second transistor et la masse. La structure comprend encore un transistor à effet de champ dont la grille et le drain sont connectés à la borne externe du circuit intégré et le substrat et la source sont connectés au collecteur du second transistor.

Le premier transistor bipolaire est défini par une première zone de diffusion d'un premier type de conductivité réalisée dans un caisson d'un second type de conductivité, et le substrat semi-conducteur d'un premier type de conductivité. Le second transistor bipolaire est défini par la première zone de diffusion et une seconde zone de diffusion dans le caisson, qui est connectée au caisson. La diode est définie par le caisson et le substrat semi-conducteur, alors que le transistor à effet de champ est défini par les deux zones de diffusion et une grille entre les deux zone de diffusion.

Cette structure a l'inconvénient d'être compliquée et ne permet pas de garantir une protection identique selon la polarité positive ou négative des décharges électrostatiques pouvant perturber le circuit à protéger.

Par souci de clarté, on rappelle qu'un transpondeur est un dispositif comprenant un moyen de traitement de données, une bobine ou antenne agencée pour recevoir un signal radioélectrique contenant des données d'identification par exemple, et pour fournir en réponse ces données sous la forme d'un signal électrique fourni au moyen de traitement, et inversement.

Les transpondeurs actuels peuvent recevoir des signaux radioélectriques induisant sur la bobine des potentiels électriques qui excédent la plage de fonctionnement usuelle comprise entre le potentiel d'alimentation fourni au moyen de traitement de données et le potentiel de masse du transpondeur.

Un objet de la présente invention est de prévoir une structure de protection contre les décharges électrostatiques pouvant être connectée à une borne externe d'un circuit à protéger, cette structure palliant les difficultés et inconvénients susmentionnés.

Un autre objet de la présente invention est de prévoir une telle structure de protection permettant l'application sur ladite borne externe de potentiels électriques supérieurs au potentiel d'alimentation dudit circuit, ainsi que des potentiels électriques inférieurs au potentiel de masse du circuit.

Un autre objet de la présente invention est de prévoir une telle structure de protection qui réponde aux préoccupations habituelles dans l'industrie des semi-conducteurs, rationalisation, d'encombrement et de coût.

Ces objets ainsi que d'autres sont atteints par la structure de protection selon la revendication 1.

Un autre objet de la présente invention est de prévoir un ensemble comprenant une structure de protection connectée à une borne externe d'un circuit à protéger afin de pallier les inconvénients susmentionnés.

Cet objet, ainsi que d'autres, sont atteints par l'ensemble qui comprend la structure et le circuit intégré selon la revendication 2.

Ces objets et caractéristiques, ainsi que d'autres, de la présente invention apparaîtront plus clairement à la lecture de la description détaillée d'un mode de réalisation préféré de l'invention, donné à titre d'exemple uniquement, en relation avec les figures jointes, parmi lesquelles :
- la figure 1 déjà citée représente un schéma électrique d'une structure de protection selon l'art antérieur, connectée à un circuit à protéger;
- la figure 2 déjà citée représente une vue en coupe transversale d'un substrat semi-conducteur dans lequel est formée la structure de la figure 1;
- la figure 3 représente une vue en coupe transversale d'un substrat semi-conducteur dans lequel est formée une structure de protection selon la présente invention;
- les figures 4A et 4B représente deux schémas électriques équivalents de la structure de protection de la figure 3; et
- la figure 5 représente une courbe illustrant la relation entre deux grandeurs électriques relatives à une borne externe d'un circuit protégé par la structure de la figure 3.

La structure de protection selon la présente invention peut être connectée à un circuit quelconque dont une borne externe est susceptible d'être le siège de perturbations provoquant une élévation anomale du potentiel électrique présent sur cette borne par rapport à la masse dudit circuit.

Dans la suite de la description, la référence A désigne ladite borne externe, la référence Vdd désigne le potentiel d'alimentation fourni audit circuit, et la référence Vss désigne le potentiel de masse de ce circuit.

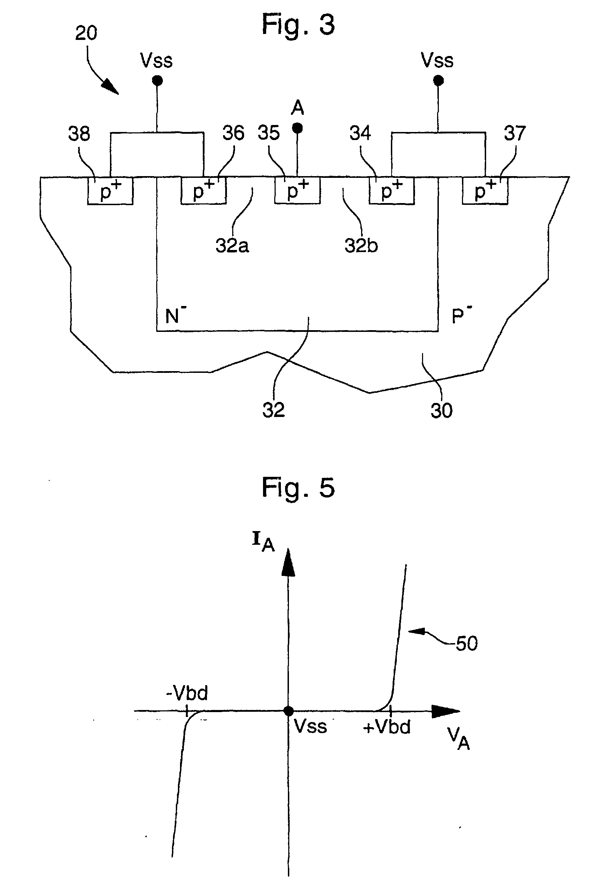

La figure 3 représente une vue en coupe transversale d'une structure de protection 20 selon la présente invention, formée dans un substrat de silicium 30. A titre illustratif uniquement, le substrat 30 a une conductivité de type P⁻.

Dans le substrat 30, on forme une zone de caisson 32 qui a conductivité de type N⁻. Puis on forme trois zones de diffusion 34 à 36 ayant une conductivité de type P⁺ dans la zone de caisson 32, ainsi que deux zones de diffusion 37 et 38 ayant une conductivité de type P⁺ dans le substrat 30.

Les zones 34 à 38 sont connectées de la manière suivante. Les zones 34 et 37 sont connectées entre elles, ainsi qu'à la masse du moyen 16, pour recevoir le potentiel Vss. De même, les zones 36 et 38 sont connectées entre elles, ainsi qu'à la masse du moyen 16. Et la zone 35 est connectée à la borne externe A.

L'homme de l'art note que la structure de protection 20 peut être réalisée selon une filière de fabrication de circuit intégré dont les étapes sont connus en soi. Ainsi, le procédé de fabrication de la structure 20 est considéré évident pour l'homme de l'art, eu égard à ses connaissances dans le domaine de la fabrication de produits semi-conducteurs. Et un tel procédé dont le produit directement obtenu est la structure de type représenté en figure 3, ne sera pas décrit de façon détaillée dans la présente description.

L'homme de l'art note également que la zone de caisson 32 n'est connectée à aucun potentiel électrique, puisque les jonctions N⁻P⁺ ne forment pas de contact ohmique entre les zones 34 à 36 et la zone 32. Autrement dit, la zone de caisson 32 est agencé comme un puits flottant.

L'homme de l'art note également que les zones 34 et 35, ainsi qu'une région 32a de la zone de caisson 32 définie par les zones 34 et 35, forment un premier transistor bipolaire de type PNP désigné ci-après par la référence 41. De même, les zones 35 et 36, ainsi qu'une région 32b de la zone de caisson 32 définie par ces deux zones, forment un second transistor bipolaire de type PNP désigné ci-après par la référence 42.

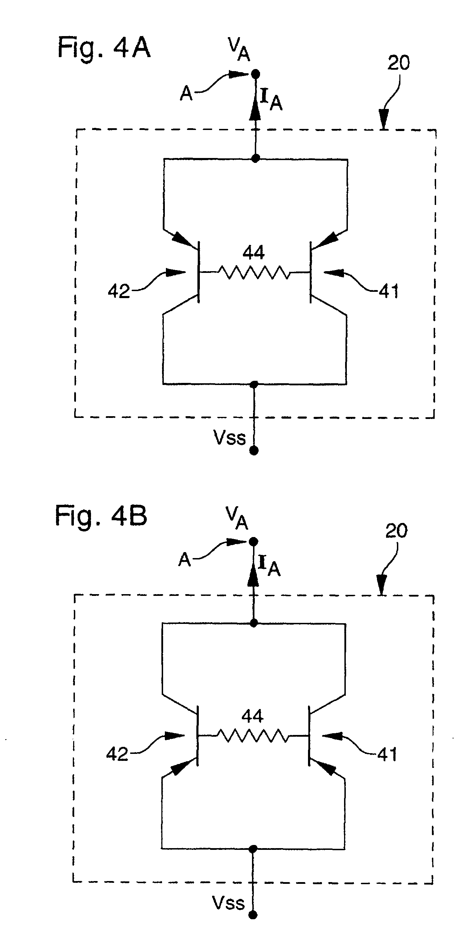

On va maintenant décrire le fonctionnement de la structure de protection 20, en se référant aux figures 4A, 4B et 5.

Il va de soi que les éléments déjà décrits ci-dessus en relation avec la figure 3, et désignés par des références déjà mentionnées, sont cités ci-après à titre illustratif uniquement, et désignent des éléments semblables représentés en figures 4A, 4B et 5.

Les figures 4A et 4B représentent deux schémas électriques équivalents de la structure de protection 20, en fonction de la polarité du potentiel électrique appliqué sur la borne externe A. Dans la suite de la description, la référence VA désigne le potentiel électrique appliqué sur la borne externe A, et la référence IA désigne l'intensité du courant électrique présent à cette borne. La figure 5 représente une courbe 50 illustrant la relation entre le potentiel électrique VA et l'intensité IA.

Considérons le cas où le potentiel VA est supérieur au potentiel Vss.

Dans ce cas, le potentiel de la zone de caisson 32 est sensiblement égal au potentiel VA, tant que le potentiel VA est inférieur à un seuil +Vbd. Ainsi, la jonction N⁺P⁻ entre la zone de caisson 32 et la zone 34 est polarisée en inverse, ainsi que jonction N⁺P⁻ entre la zone de caisson 32 et la zone 36. En conséquence, comme le représente la figure 5, l'intensité IA est nulle, quand le potentiel VA est compris entre le potentiel Vss et le seuil +Vbd.

On notera que le seuil +Vbd représente le seuil de claquage des jonctions P⁺N⁻ entre les zones 34 à 36 et la zone de caisson 32. A titre illustratif uniquement, le seuil de tension Vbd peut être de l'ordre de 16 V, pour des procédés de fabrication de produits semi-conducteurs usuels.

Quand le potentiel VA devient supérieur au seuil +Vbd, il en résulte un claquage des jonctions P+N-susmentionnées. La jonction P⁺N⁻ entre la zone 35 et la zone de caisson 32 ainsi polarisée correspond à une diode polarisée en direct. Et la jonction P⁺N⁻ entre la zone 34 et la zone de caisson 32 ainsi polarisée correspond à une diode polarisée en inverse. De même, la jonction P+N-entre la zone 36 et la zone de caisson 32 ainsi polarisée correspond à une diode polarisée en inverse. La zone de caisson 32 n'est plus un puits flottant, et le potentiel des zones 34 et 36 est fixé au seuil +Vbd.

Autrement dit, quand le potentiel VA devient supérieur au seuil +Vbd, un effet bipolaire apparaît et l'intensité IA augmente brutalement, comme le représente la figure 5. La structure de protection 20 est alors équivalente électriquement aux transistors bipolaires 41 et 42 connectés tels que représentés en figure 4A et décrits ci-après.

La zone 35 constitue les émetteurs des transistors 41 et 42, et les zones 34 et 36 constituent respectivement les collecteurs de ces deux transistors. Et les régions 32a et 32b constituent respectivement les bases des transistors 41 et 42. Ces dernières sont connectées entre elles par une résistance électrique 44 qui correspond au chemin résistif dans la zone de caisson 32 entre les régions 32a et 32b.

Considérons maintenant le cas où le potentiel VA est inférieur au potentiel Vss.

La situation est analogue à celle décrite précédemment. L'intensité IA est nulle, quand le potentiel VA est compris entre le potentiel Vss et un seuil -Vbd qui est égal à l'opposé du seuil +Vbd. Quand le potentiel VA est inférieur au seuil -Vbd, la structure de protection 20 est équivalente électriquement aux transistors bipolaires 41 et 42 connectés tels que représentés en figure 4B et décrits ci-après.

La zone 35 constitue les collecteurs des transistors 41 et 42, et les zones 34 et 36 constituent respectivement les émetteurs de ces deux transistors, les régions 32a et 32b constituant respectivement les bases des transistors 41 et 42.

L'homme de l'art note que la caractéristique entre le potentiel VA et l'intensité IA de la borne externe A du circuit protégé par la structure 20, réalise deux fonctions particulièrement avantageuses par rapport aux structures de protection classiques de type susmentionné.

En effet, la présence destructrice de décharges électrostatiques par exemple sur la borne externe du circuit protégé, n'induit pas la fourniture à ce circuit d'un courant électrique d'intensité élevée, ce qui réalise la fonction de protection contre des surtensions en-dehors de la plage de fonctionnement usuelle.

En outre, le fonctionnement de la structure de protection selon la présente invention permet la mise en oeuvre de cette structure dans le cas d'une application à un circuit devant fonctionner à des potentiels électriques supérieurs au potentiel d'alimentation (qui est typiquement de l'ordre de +5 V), ou inférieurs au potentiel de masse du circuit.

L'homme de l'art notera que la structure de protection selon la présente invention peut être réalisée par des étapes de fabrication d'une filière classique dans l'industrie des produits semi-conducteurs.

L'homme de l'art notera également que la structure de protection selon la présente invention est peu complexe, peu encombrante, et donc peu coûteuse.

Il va de soi pour l'homme de l'art que la description détaillée ci-dessus peut subir diverses modifications sans sortir du cadre de la présente invention. A titre d'exemple, on peut réaliser une structure selon la présente invention dans un substrat de silicium ayant une conductivité de type inverse à celle du substrat décrit en relation avec les figures 3 et suivantes.

## Revendications

1. Structure de protection (20) pouvant être connectée à une borne externe (A) d'un circuit (16) à protéger contre des décharges électrostatiques, cette structure étant formée par trois zones de diffusion (34, 35, 36) qui ont un premier type de conductivité, et qui sont formées dans une zone de caisson flottante (32) ayant un second type de conductivité, ladite zone de caisson flottante étant formée dans un substrat semi-conducteur (30) ayant le premier type de conductivité, **caractérisée en ce que** deux (34, 36) des trois zones sont connectées à un potentiel électrique de référence (Vss), et **en ce que** l'autre zone (35) peut être connectée à la borne externe, les trois zones étant arrangées de manière à définir des transistors bipolaires (41, 42) dont la base se trouve dans la zone de caisson flottante.

2. Ensemble comprenant une structure de protection (20) selon la revendication 1 et un circuit intégré à protéger par la structure, **caractérisé en ce que** ledit circuit intégré (16) est un transpondeur connecté à une antenne émettrice-réceptrice, et **en ce que** ladite borne externe (A) est connectée à l'une des bornes de cette antenne, de telle sorte que ledit transpondeur est protégé par ladite structure de protection.

3. Ensemble selon la revendication 2, **caractérisé en ce que** ladite structure (20) et le circuit intégré (16) sont formés de façon monolithique dans le même substrat semi-conducteur (30).

## Patentansprüche

1. Schutzstruktur (20), die an einen externen Anschluss (A) einer vor elektrostatischen Entladungen zu schützenden Schaltung (16) angeschlossen werden kann, wobei diese Struktur durch drei Diffusionszonen (34, 35, 36) gebildet ist, die von einem ersten Leitfähigkeitstyp sind und in einer schwebenden Wannenzone (32) ausgebildet sind, die von einem zweiten Leitfähigkeitstyp ist, wobei die schwebende Wannenzone in einem Halbleitersubstrat (30) ausgebildet ist, das von dem ersten Leitfähigkeitstyp ist, **dadurch gekennzeichnet, dass** zwei (34, 36) der drei Zonen mit einem elektrischen Referenzpotential (Vss) verbunden sind und dass die andere Zone (35) an den externen Anschluss angeschlossen sein kann, wobei die drei Zonen so beschaffen sind, dass sie Bipolartransistoren (41, 42) definieren, deren Basis sich in der schwebenden Wannenzone befindet.

2. Baueinheit, die eine Schutzstruktur (20) nach Anspruch 1 sowie eine durch die Struktur zu schützende integrierte Schaltung umfasst, **dadurch gekennzeichnet, dass** die integrierte Schaltung (16) ein an eine Sende/Empfangs-Antenne angeschlossener Transponder ist und dass der externe Anschluss (A) an einen der Anschlüsse dieser Antenne angeschlossen ist, so dass der Transponder durch die Schutzstruktur geschützt ist.

3. Baueinheit nach Anspruch 2, **dadurch gekennzeichnet, dass** die Struktur (20) und die integrierte Schaltung (16) monolithisch im selben Halbleitersubstrat (30) ausgebildet sind.

## Claims

1. Protective structure (20) able to be connected to an external terminal (A) of a circuit (16) to be protected against electrostatic discharges, this structure being formed by three diffusion regions (34, 35, 36) which have a first type of conductivity and which are formed in a floating well region (32) which has a second type of conductivity, said floating well region being formed in a semi-conductor substrate (30) of the first type of conductivity, **characterised in that** two (34, 36) of the three regions are connected to a reference electric potential (Vss), and **in that** the other region (35) can be connected to the external terminal, the three regions being arranged in order to define bipolar transistors (41, 42) whose the base is in the floating well region.

2. Assembly including a protective structure (20) according to claim 1 and an integrated circuit to be protected by the structure, **characterised in that** said integrated circuit (16) is a transponder connected to a transceiver antenna, and **in that** said external terminal (A) is connected to one of the terminals of said antenna, so that said transponder is protected by said protective structure.

3. Assembly according to claim 2, **characterised in that** said structure (20) and the integrated circuit (16) are formed in a monolithic manner in the same semi-conductor substrate.
